Europäisches Patentamt

European Patent Office

Office européen des brevets

(19)

(11) Publication number: **0 029 855**
**B1**

# (12) EUROPEAN PATENT SPECIFICATION

(45) Date of publication of patent specification: **29.10.86**

(51) Int. Cl.⁴: **G 06 F 13/00, G 11 C 7/00**

(21) Application number: **80901303.0**

(22) Date of filing: **09.06.80**

(88) International application number:
PCT/US80/00713

(87) International publication number:
WO 80/02881 24.12.80 Gazette 80/29

## (54) MICROCOMPUTER WITH MPU-PROGRAMMABLE EPROM.

(30) Priority: **12.06.79 US 47674**

(43) Date of publication of application:
**10.06.81 Bulletin 81/23**

(45) Publication of the grant of the patent:
**29.10.86 Bulletin 86/44**

(84) Designated Contracting States:
**DE FR GB NL**

(56) References cited:
US-A-3 798 612
US-A-3 813 649
US-A-3 938 104
US-A-3 944 984
US-A-3 993 980
US-A-4 020 469
US-A-4 093 998
US-A-4 156 926
US-A-4 179 748
Kerber, "Build a prom programmer and program your own devices", ELECTRONIC DESIGN, vol.2 4, no. 22, Oct. 25, 1976, pp. 172-176

(73) Proprietor: **MOTOROLA, INC.**
**1303 East Algonquin Road**
**Schaumburg, Illinois 60196 (US)**

(72) Inventor: **THOMPSON, Robert Ritchie**
**8550 Ulmerton Road**
**Largo, FL 33540 (US)**

(74) Representative: **Smith, Norman Ian et al**
**F.J. CLEVELAND & COMPANY 40-43 Chancery Lane**
**London WC2A 1JQ (GB)**

(56) References cited:

Mars et al., "Design of a read-only-memory programmer", Int. J. Electronics, vol. 43, no. 1, 1977, pp. 1-18

"Complete microcomputer control system develops and debugs programs on line in high level language", COMPUTER DESIGN, March 1977, pp. 146, 148

"A programming controller for the 2708 eprom copies data in-circuit" ELECTRONIC DESIGN, vol. 25, no. 8, April 12, 1977, p. 148

## Description

This invention relates generally to a microcomputer arrangement having programmable read only memory (PROM) which may be programmed using the central processing unit (CPU) of the microcomputer.

A known microcomputer arrangement is described in the precharacterising portion of claims 1 and is also known from US—A—4 093 998.

Microcomputers are sophisticated, general purpose logic devices which can be programmed to perform a wide variety of useful control functions in industrial and communications equipment, large-scale and medium-scale computer peripheral and terminal hardware, automobiles and other transportation media, amusement and education devices and the like. Generally, an entire spectrum of microcomputers is presently available in the commercial marketplace. The MC6801 microcomputer soon to be commercially available from Motorola Inc., is an 8-bit microcomputer comprising a CPU, 128 bytes of random access memory (RAM, 2 K bytes of EPROM, a 16-bit timer, and four I/O ports for communicating with external equipment.

It is known in microcomputer technology to provide an EPROM as a component part of an overall single-chip microcomputer. For example, the MCS8748 commercially available from Intel Corporation is a single-chip microcomputer which includes a EPROM. The MCS8748 EPROM is programmed utilizing a microcomputer development system. The microcomputer development system requires an independent processor, operating under the control of an EPROM loading program, to program the EPROM. The MCS8748 contains at least three pins, out of a total of 40 pins, whose function is dedicated to programming the EPROM. A TO pin is set low to select the programming mode; an EA pin is raised to 25 volts to activate the programming mode; and a PROG pin is raised to 25 volts for a 50 millisecond pulse to program data into the EPROM.

In US—A—4 093 998 there is disclosed the use of central processor (CPU) for programming an EPROM via I/O ports for communicating with address, data and control program information in the presence of a specific programming potential. However, it is to manually insert and retrieve an EPROM programming circuit module which is used to aid in such programming and in addition specific pins are allocated to the programming process only.

It is desirable to reduce the dedicated programming pins in a microcomputer having an EPROM, since such programming pins are used only during the EPROM programming operation and might otherwise be more usefully employed in providing other I/O or control functions to the microcomputer.

The invention therefore provides microcomputer arrangements as defined in claims 1 and also a method of programming the EPROM of such an arrangement as defined in claim 4. In this way the number of pins dedicated solely to programming of the EPROM can be reduced. Further features of the invention are characterised in the subordinate claims.

With reference to patent application numbers GB—A—2 022 884 (publ. 19.12.79) FR—A—2 461 301 (publ. 30.1.81) and DE—A—2 916 658 (publ. 31.10.79) the applicant has voluntarily limited the scope of the present application and submitted separate claims for the United Kingdom, France and Federal Republic of Germany respectively.

The invention will now be described by way of example only with particular reference to the accompanying drawings in which:

Figure 1 shows a block diagram of a single-chip microcomputer, including an EPROM, as a portion of a system for programming and verifying the EPROM.

Figure 2 shows a block diagram of a single-chip microcomputer which embodies the present invention.

Figure 3 illustrates a pin-out arrangement of the single-chip microcomputer which embodies the present invention.

Figure 4 illustrates a block diagram of a portion of the internal microcomputer structure, including the CPU and the EPROM, which embodies the present invention.

Figure 5 shows a logic diagram of a portion of the EPROM control register.

Figure 6 shows a logic diagram of the circuit for enabling the address and data latches associated with EPROM array.

Figure 7 shows a logic diagram of the data latch associated with the EPROM array.

Figure 8 shows a logic diagram of the address buffer/latch associated with the EPROM array.

Figure 9 shows a circuit diagram of the EPROM world line decoder.

Figure 10A and 10B together show a circuit diagram of a portion of the EPROM array, including a portion of the column decoding circuitry.

Figure 11 shows a ·circuit diagram of a representative one of the sense amps associated with the EPROM array.

Figure 12 shows a logic diagram of the sense amp enabling circuitry.

Figure 13 shows a combined logic and circuit diagram of a portion of the $\overline{RESET}/V_{pp}$ circuit.

Figure 14 shows a logic diagram of the strobe control 1 buffer circuit for generating an address strobe (AS) signal.

Fig. 15 shows a logic diagram of a representative one of the port 3 I/O buffers.

Fig. 16 shows a logic diagram for generating certain control signals used in the port 3 control logic.

Fig. 17 shows a logic diagram for generating a control signal used in the port 3 and port 4 control logic.

Figs. 18 and 19 show logic diagrams illustrating the port 3 control logic.

Fig. 20 shows a logic diagram illustrating a representative one of the port 4 I/O buffers.

Fig. 21 shows a logic diagram illustrating a portion of the port 4 control logic.

Fig. 22 shows a combination logic and circuit diagram of the serial communication interface.

Fig. 23 represents a memory map of the address space of the single-chip microcomputer which embodies the present invention.

Figure 24 shows a logic diagram illustrating the clock generating circuitry.

Fig. 25A shows a logic symbol of a push-pull inverter, and

Fig. 25B shows the corresponding circuit diagram.

Detailed Description of the Invention

Table of Contents

General Description
    EPROM Programming and Verifying System
    Microcomputer Architecture

Detailed Description
    EPROM Programming Circuitry
    EPROM Control Register
    EPROM Address and Data Latches
    EPROM Word Line Decoding Circuitry
    EPROM Colum Decoding Circuitry
    Miscellaneous Circuitry
    EPROM Programming Monitor

Operation of Preferred Embodiment

General Description

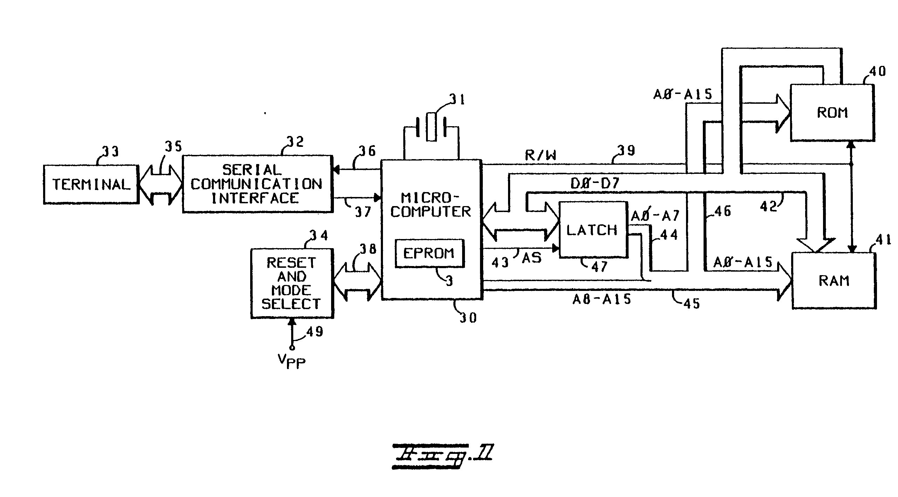

The present invention constitutes both a method and apparatus for programming and verifying the contents of an EPROM in a single-chip microcomputer. In a preferred embodiment of the invention, the microcomputer with EPROM forms part of a program development system which now will be described with reference to Fig. 1.

EPROM Programming and Verifying System With reference to Fig. 1, a block diagram of an exemplary program development system is shown, in which a microcomputer 30 with EPROM 3 forms the central component. Coupled to Microcomputer 30 via I/O lines 36 and 37 is a serial communication interface 32, which provides the essential communications interface between microcomputer 30 and the user terminal 33. Terminal 33 is coupled to serial communication interface 32 by a plurality of data and control lines represented by bus 35. Using the terminal 33, the operation of microcomputer 30 and its associated peripheral devices may be controlled in such a manner as to develop a computer program, load such program into EPROM 3, and verify that the program has been correctly loaded.

A reset and mode select circuit 34 is connected to microcomputer 30 through several control lines shown generally as bus 38. The reset and mode select circuit 34 is coupled to a high voltage source $V_{pp}$ over line 49, which high voltage source is used in a controlled manner to program the EPROM. As will be further explained hereinafter, the reset and mode select circuit 34 is used to select the operational mode of microcomputer 30, as well as to supply $V_{pp}$ to EPROM 3 and its associated control circuitry. While several modes will be mentioned in the ensuing description, only mode 0, the EPROM programming mode is important in the context of the present invention.

External ROM 40 is connected to microcomputer 30 by means of data bus 42 comprising data lines D0—D7, address bus 46 comprising address lines A0—A15, and read/write (R/W) line 39. External ROM 40 is used in a preferred embodiment to store a programming monitor, which is a computer program especially designed for programming and verifying the contents of EPROM 3. As will be further explained below, the central processing unit (CPU) of microcomputer 30 is controlled by the programming monitor stored in external ROM 40 to load and verify the contents of EPROM 3.

External RAM is also connected to microcomputer 30 by means of data bus 42, address bus 46, and R/W line 39. External RAM 41 may be used for program development purposes in the system shown in Fig. 1; however, its presence in the system shown in Fig. 1 and its operation are not essential to the present invention and will not be further described.

Also shown in Fig. 1 is a latch 47 for latching the low-order address bits A0—A7 received from microcomputer 30 when it is operated in the expanded, multiplexed mode (mode 6) of operation. In such mode Port 3 of microcomputer 30, from which both data D0—D7 and the low-order address A0—A7 are multiplexed, must be connected to latch 47 to temporarily latch the low-order address A0—A7 so that such may be concatenated with the high-order address A8—A15. Latch 47 latches the low-order address A0—A7 in response to an address strobe (AS) received from microcomputer 30 over line 43. The low-order address bits are output from latch 47 over bus 44, with which they are joined by the high-order address bits output from microcomputer 30 over bus 45 to form address bus 46.

A parallel resonance crystal 31 is shown connected to microcomputer 30. Alternatively, microcomputer 30 may be driven by an external clock source.

In a preferred embodiment of the invention, microcomputer 30 comprises the MC68701 soon to be commercially available from Motorola Inc. The serial communication interface 32 and the reset and mode select circuit 34 may be as shown in Fig. 22. The serial communication interface 32 shown in Fig. 22 provides an RS232C interface capability. Terminal 33 may be any of several commercially available terminals which utilize the commonly available RS232C interface.

With reference to Fig. 22, the transmit data (T×D) line 70 is connected to pin 4 of Port 2 of microcomputer 30 through logic gate 80 which may comprise a commercially available MC1488 from Motorola, Inc. The receive data line (R×D) is connected to pin 3 of Port 2 of microcomputer 30 over line 71 through logic gate 83, which may comprise an MC1489 device from Motorola Inc. Logic gate 83 forms part of a logic circuit comprising logic gates 81 and 82 for handling the terminal control signals, including DSR (Data Set Ready), CTS (Clear To Send), DCD (Data Carrier Detect), and DTR (Data Terminal Ready). Logic gate 81 may be of the same type as logic gate 80, and logic gate 82 may be of the same type as logic gate 83.

Regarding the reset and mode select circuit shown in the lower portion of Fig. 22, lines 72—74 are connected to pins 0—2, respectively, of Port 2, and line 75 is connected to the $\overline{RESET}/V_{pp}$ pin of microcomputer 30. To reset microcomputer 30, switch S1 is depressed to provide low signal levels at pins P20—P22 causing microcomputer 30 to revert to mode 0, the reset mode. During the EPROM loading operation, the high voltage source of 25 volts is provided at the $\overline{RESET}/V_{pp}$ pin by depressing switch S2.

The frequency of crystal 31 in a preferred embodiment as shown in Fig. 1 should be either 4.9152 MHz or 2.5476 MHz in order to give a standard band rate for the serial communication interface 32.

Latch 47 shown in Fig. 1 may be a transparent octal D-type latch available as part number SN74LS373 from Texas Instruments. External ROM 40 and external RAM 41 may be any of several commercially available devices. In a preferred embodiment, external ROM 40 will soon be available in the form of a programmed ROM (PROM) from Motorola, Inc. and will contain substantially the computer program (programming monitor) attached hereto as Appendix I.

Microcomputer Architecture

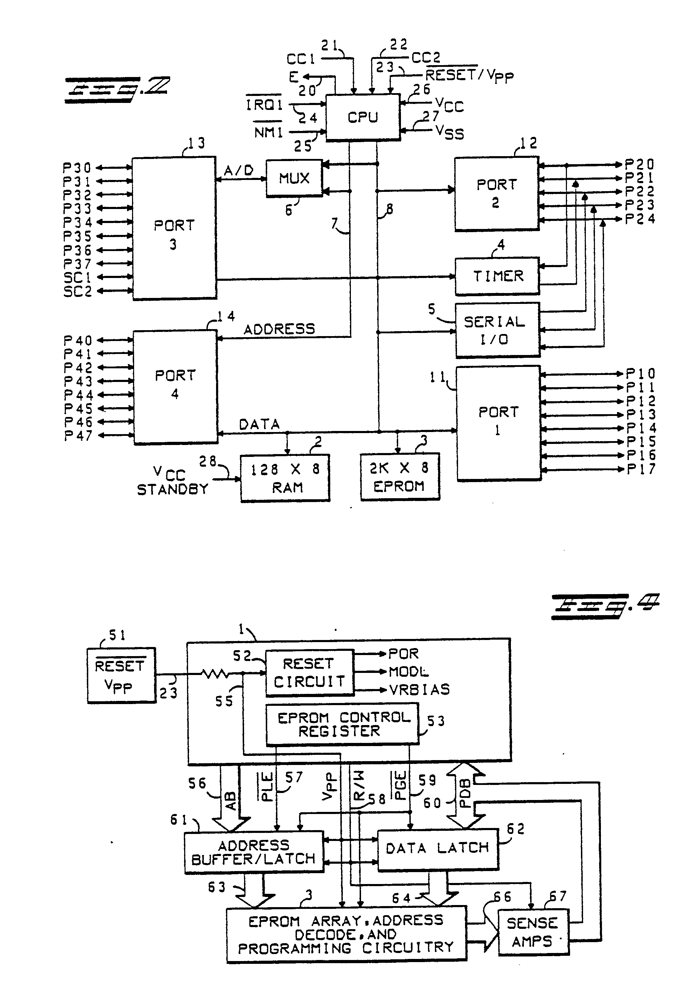

With reference to Fig. 2, a block diagram of the single-chip microcomputer 30 embodying the present invention is shown.

The microcomputer shown in Fig. 2 comprises a central processor (CPU), a random access memory (RAM) 2, an erasable programmable read-only-memory (EPROM) 3, a timer circuit 4, and a serial I/O portion 5 as major functional blocks. The microcomputer shown in Fig. 2 also comprises a multiplexer (MUX) 6, an internal address bus 7, an internal data bus 8, and four I/O ports 11—14. CPU 1 may be connected to an external crystal through crystal connections CC1 and CC2, and it supplies an external clock signal E to other system components. CPU is also responsive to a $\overline{RESET}$ signal or $V_{pp}$ potential over line 23, an interrupt request signal $\overline{(IRQ1)}$ over line 24, a non-maskable interrupt signal $\overline{(NMI)}$ over line 25, a power supply signal ($V_{cc}$) over line 26, and a ground signal ($V_{ss}$) over line 27. The RAM 2 receives a $V_{cc}$ standby supply over line 28 to preserve data in the RAM in the event of a power failure.

Ports 1, 3, and 4 are 8-bit ports, and port 2 is a 5-bit port. The eight lines, P10—P17, into port 1 are dedicated solely to parallel I/O operations. The lines into ports 2—4 may be configured in different ways depending upon one of several possible modes of operating the microcomputer shown in Fig. 2. Port 2 has five lines P20—P24. Port 3 has eight lines P30—P37 and two strobe control lines, SC1 and SC2. Control lines SC1 and SC2 into port 3 serve as input and output strobes, SC1 in particular serving as an address strobe to latch 47 of Fig. 1. Port 4 has eight lines P40—P47.

In the single chip mode (mode 7) all I/O lines of ports 2—4 can be programmed to serve either as inputs or outputs, in accordance with a data direction register associated with each port. In the expanded non-multiplexed mode (mode 5) lines P30—P37 of port 3 function as the external data bus (D0—D7), and lines P40—P47 of port 4 serve as the low-order address-lines A0—A7). If any of the eight address lines are not needed in this mode the remaining lines may be configured as I/O. In the expanded multiplexed mode (mode 6), lines P30—P37 of port 3 serve both as the external data bus (D0—D7) and as the low-order address bus (A0—A7). In this mode, lines P40—P47 of port 4 serve as the high-order address lines (A8—A15). If any of the eight high-order address lines are not needed in this mode the remaining lines may be configured as I/O.

In all three of the above mentioned modes, lines P20—P24 of port 2 can be configured either as input or output lines by a data direction register associated with this port. Port 2 also provides access to the serial I/O communications capability and the programmable timer capability of the microcomputer. Pins P20—P22 of port 2 are used to select the operational mode of microcomputer 30 during reset. When $\overline{RESET}$ goes high, pins P20—P22 latch mode control signals PC0—PC2.

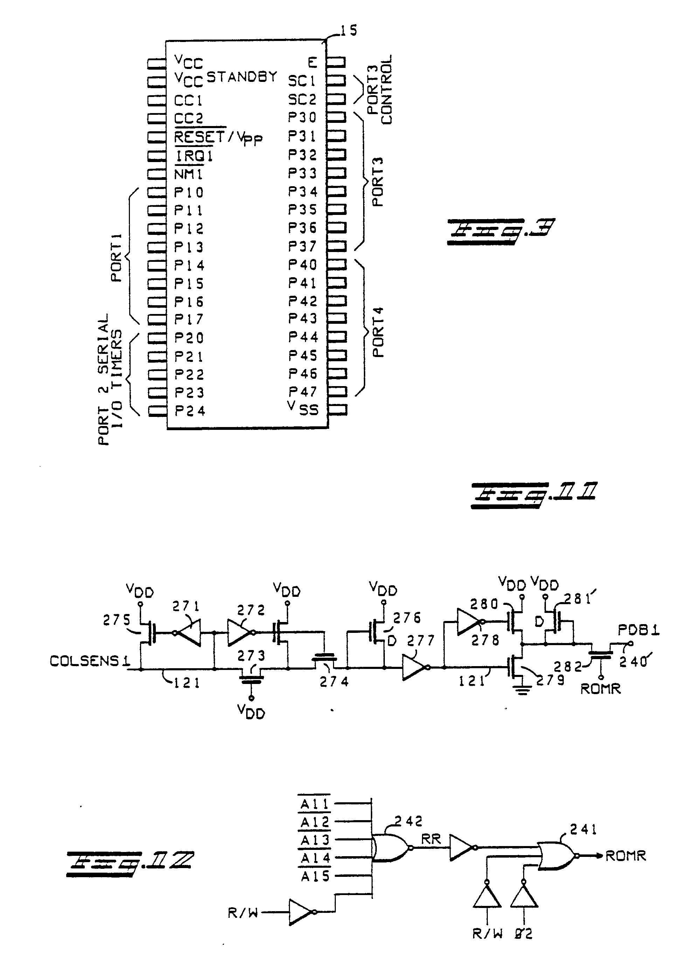

Fig. 3 provides a schematic representation 15 of the pin-out arrangement of the microcomputer of Figs. 1 and 2.

Detailed Description

The single-chip microcomputer 30 shown in Figs. 1 and 2 comprises special circuitry for controlling the programming and verification of the contents of EPROM 3. Such circuit permits the CPU1 of microcomputer 30 to carry out the programming and verification functions under the control of the program monitor resident in the external ROM 40. A detailed description of the specific EPROM-related circuitry, as well as such other circuitry of microcomputer 30 as is required to fully describe the invention, will now be given.

EPROM Programming Circuitry

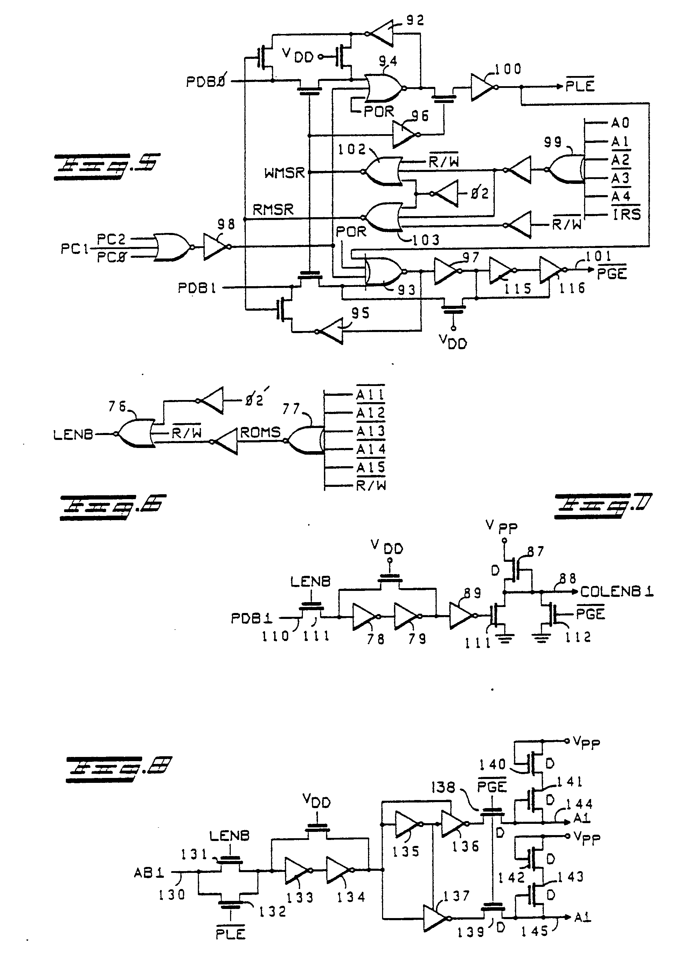

Referring now to Fig. 4, a block diagram is shown of a portion of the internal structure of microcomputer 30, including CPU1 and EPROM 3. In CPU1 the $\overline{RESET}$ pin in the present invention also serves to provide the programming potential $V_{pp}$ over lines 23 and 55 to the EPROM 3. CPU 1 of the present invention also contains an EPROM control register 53 loadable from the internal data bus of the CPU. Details of the EPROM control register 53 are given below under the subheading of the same name. The RESET/$V_{pp}$ pin performs three functions for microcomputer 30. The first of these three functions is to reset microcomputer 30, and the potential on the RESET/$V_{pp}$ pin must be below 0.8 volts for this to occur. The second function is for normal program execution, wherein EPROM 3 is only being read, and the potential on the RESET/$V_{pp}$ pin must be at a logic 1 level (5.0 volts at 8 ma). The third function of the RESET/$V_{pp}$ pin is to supply the programming potential $V_{pp}$ to EPROM 3. The programming potential is 25 volts at a current of 30 ma maximum.

During the normal (read) operation of EPROM 3 the address buffer/latch 61 and data latch 62 are not enabled, so address information flows through address bus 56, address buffer/latch 61 and address bus 63 directly to EPROM 3, and data information flow directly through the internal peripheral data bus (PDB) 60, data latch 62, and data bus 64 to EPROM 3.

EPROM control register 53 provides temporary storage for at least two control bits $\overline{PGE}$ (program enable) and $\overline{PLE}$ (program latch enable). For normal (read) operation of EPROM 3 both $\overline{PGE}$ and $\overline{PLE}$ are a logical 1. During the programming of EPROM 3 $\overline{PLE}$ is set to 0 in order to latch address and data information in the address buffer/latch 61 and data latch 62, respectively. During that portion of a programming operation when it is specifically desired to apply the programming potential $V_{pp}$ to EPROM 3 $\overline{PGE}$ is momentarily set to 0 for a time duration of approximately 50 msec. During read operations of ERPOM 3, the R/W signal transmitted over line 58 is at a logical 1 and during write operations R/W signal is at a logical 0. During read operations, sense amps 67 amplify the output signals from EPROM 3 representing the individual bits in a word corresponding to a designated address and transmit the corresponding bits over PDB 60 to CPU 1.

EPROM Control Register

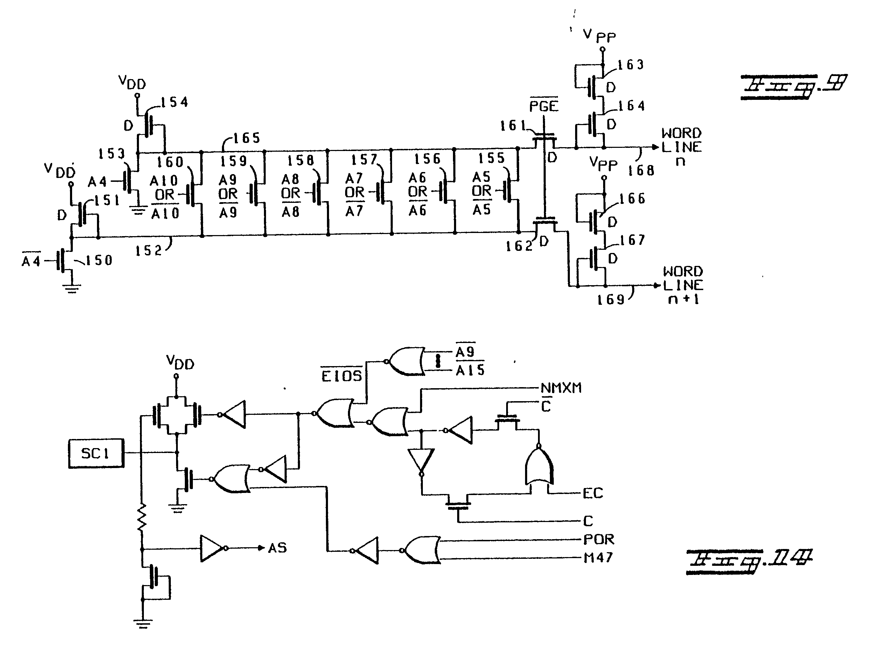

Fig. 5 shows a logic diagram of that portion of the EPROM control register 53 which stores the $\overline{PGE}$ and $\overline{PLE}$ control bits. The $\overline{PLE}$ control bit is loaded by the CPU 1 into the individual $\overline{PLE}$ register cell comprising NOR gate 94 and inverter 92 by means of PDB 0. The $\overline{PGE}$ bit is loaded by the CPU 1 into the corresponding register cell of the EPROM control register 53, comprising NOR gate 93 and inverter 94, by means of PDB 1. The output of the $\overline{PGE}$ register cell is transmitted through push-pull inverters 115 and 116, whose circuit diagram is illustrated in Fig. 25B.

A write operation to the EPROM control register 53 is enabled when SIGNAL WMSR goes high. This occurs when $\overline{R/W}$ is low, Ø2 is high, and the output of NOR gate 99 is high. NOR gate 99 goes high when address $14 (using hexadecimal notation), representing the address of EPROM control register 43 in the microcomputer address space, is applied as an input to NOR gate 99 along with the internal register select $\overline{(IRS)}$ signal in a low state. The inverse of the $14 address, represented symbolically in Fig. 5 by $\overline{A4}$ A3 $\overline{A2}$ A1 A0, allows the output of NOR gate 99 to go high.

A read operation of EPROM control register 53 is enabled under the same conditions except that the $\overline{R/W}$ signal must be high. For either $\overline{PGE}$ or $\overline{PLE}$ to be in the low state, each of the program control bits PC0—PC2 must be in their low state representing mode 0, the programming mode. In addition the power-on reset (POR) signal must be in its low state.

EPROM Address and Data Latches

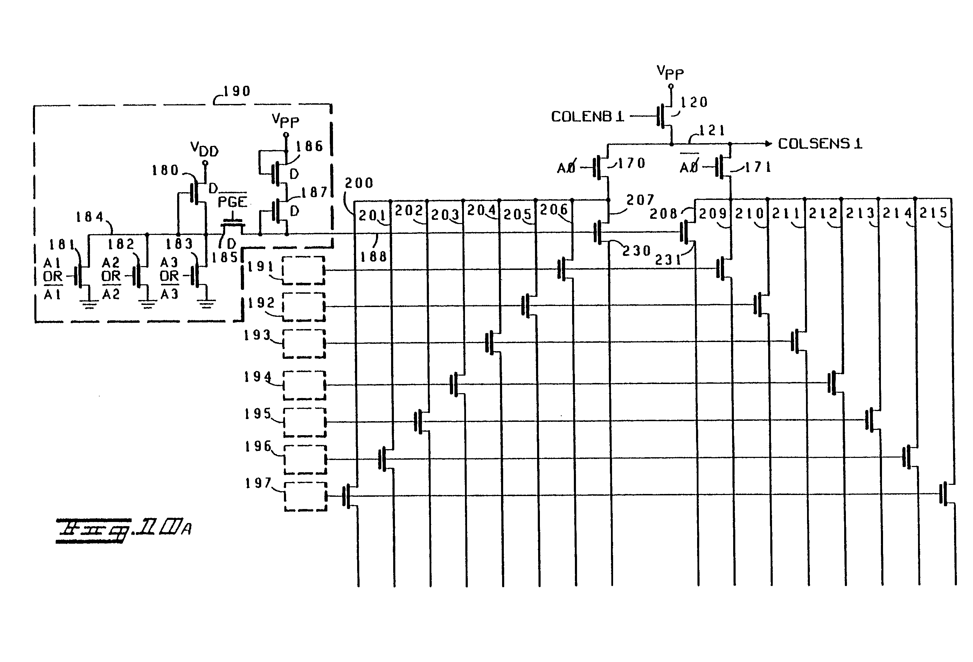

Fig. 6 shows a logic diagram of the circuit for enabling the address buffer/latch 61 and the data latch 62 associated with the EPROM array. The latch enable (LENB) output of NOR gate 76 is high when Ø2' is high, $\overline{R/W}$ is low, and the ROMS output of NOR gate 77 is high. Signal ROMS is high wnen $\overline{R/W}$ is low and when an address representing an EPROM address appears on the microcomputer internal address bus 56 (Fig. 4). The EPROM memory space is $F800—$FFFF as shown in Fig. 23, and this range of addresses is represented when A11—A15 are all high. The inverse of this condition permits NOR gate 77 to be enabled, and such inverse condition is represented symbolically in Fig. 6 by $\overline{A15}$ $\overline{A14}$ $\overline{A13}$ $\overline{A12}$ $\overline{A11}$.

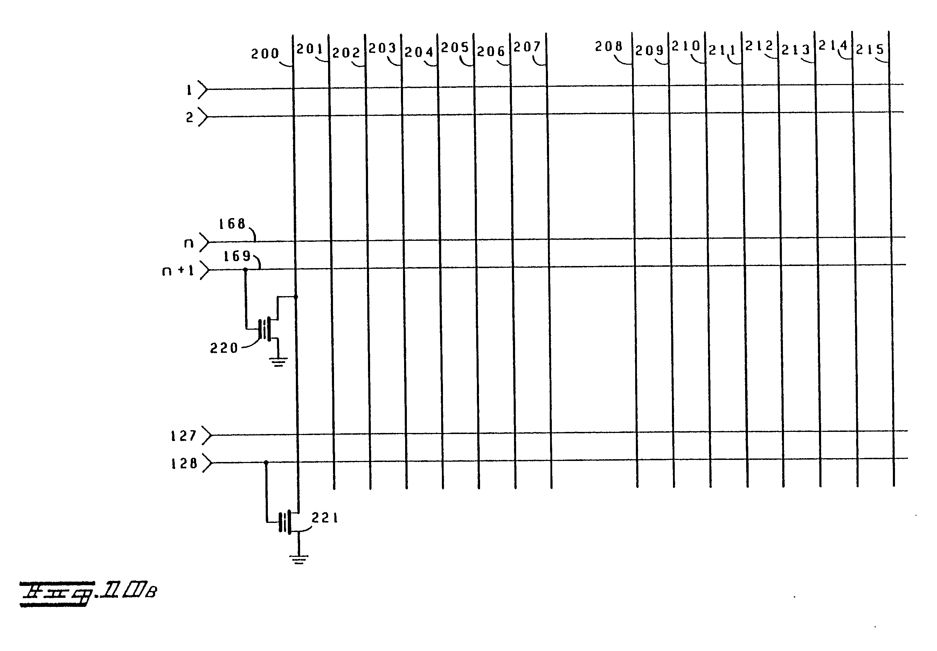

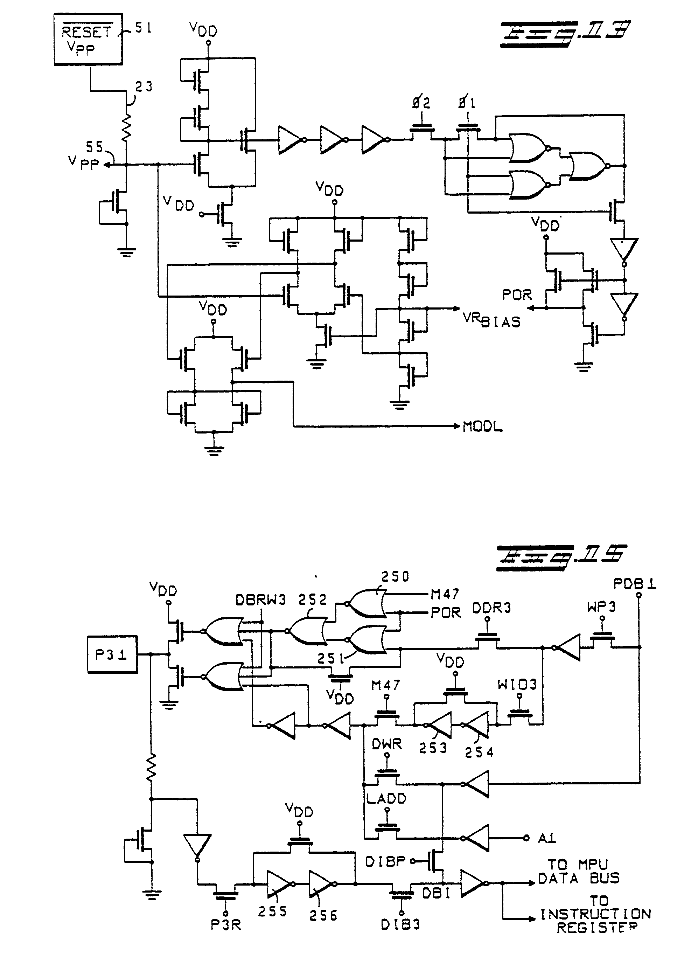

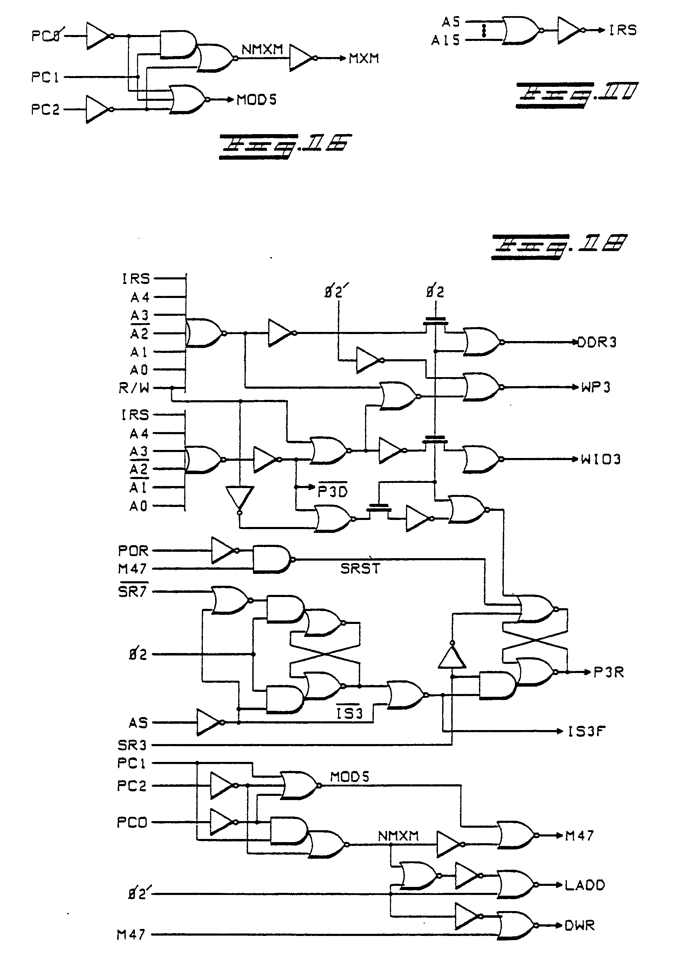

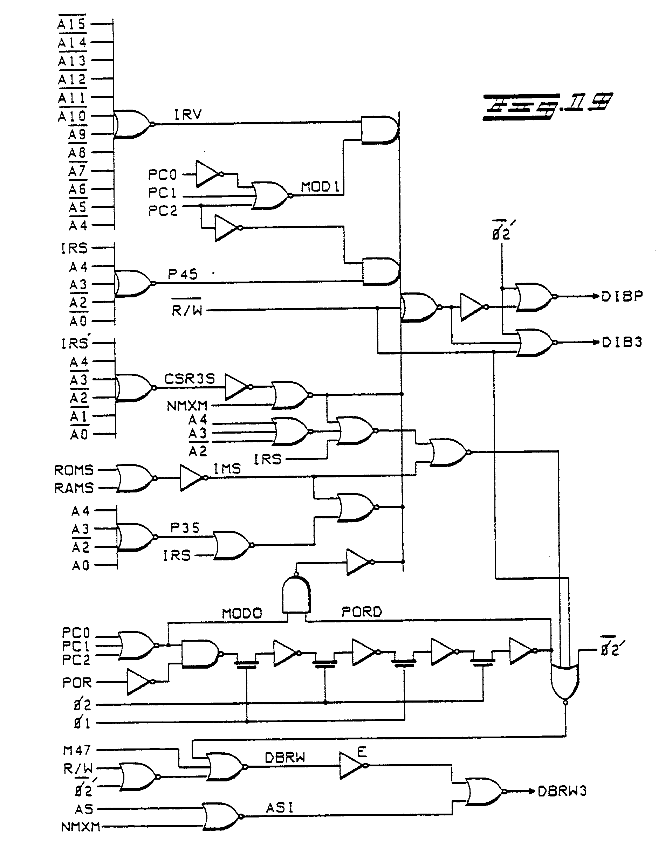

Fig. 7 shows a logic diagram of a representative one of the eight data latches associated with the EPROM array. A representative one of the PDB lines 110 is coupled to the data latch by means of transfer gate 111, which is enabled by signal LENB. The data latch itself comprises inverters 78 and 79, the output of inverter 79 being fed back to input of inverter 78. The data latch 62 also includes an inverter 89, enhancement mode gates 111 and 112, and depletion mode gate 87. The drain of depletion mode gate 87 is coupled to $V_{pp}$. Line 88 is a high voltage line during the programming mode. The column enable signal COLENBi generated over line 88 is applied to gate 120 of Fig. 10A, permitting $V_{pp}$ to be conducted through gate 120 to line 121 for a purpose to be later described.

Fig. 8 shows a logic diagram of a representative one of the eleven address buffer/latches associated with the EPROM array. Line 130 represents one of the address bus lines and is coupled to the address buffer/latch through either transmission gate 131, which is enabled by signal LENB, or by transmission gate 132, which is enabled by the $\overline{PLE}$ signal. $\overline{PLE}$ is normally high during EPROM read operations, but is low during a programming operation, so an address signal is transmitted into the address buffer/latch only when LENB is high during a programming operation.

The data buffer comprises inverters 133 and 134 coupled in a feedback arrangement. The data buffer/latch also comprises inverters 135—137, connected in a push-pull arrangement for higher speed operation, and depletion mode gates 138 and 139 both enabled by the $\overline{PGE}$ signal. Connected to the source of gate 138 is a pull-up depletion mode device 141 whose source is connected to line 144 and whose drain is connected to the source of another depletion mode gate 140. The gate and drain of device 140 are connected to $V_{pp}$. Depletion mode devices 142 and 143 are connected in a similar arrangement to devices 140 and 141, the gate and source of device 143 being connected to line 145. Line 1—4 transmits the true state of the particular address bit $A_i$ which is latched, and line 145 transmits the inverse $\overline{A_i}$ of the latched address bit. Lines 144 and 145 are both high voltage lines during the programming mode.

EPROM Word Line Decoding Circuitry

Fig. 9 shows a circuit diagram of a representative one of the EPROM word line decoders, of which there are 64 in the preferred embodiment, each generating a true and complement output. The world line decoder shown in Fig. 9 comprises gates 153 and 150 which are responsive to address bits A4 and $\overline{A4}$, respectively. A depletion mode device 151 has its drain connected to $V_{DD}$ and its gate and source connected to the drain of device 150 as well as to line 152. A depletion mode device 154 has its drain connected to $V_{DD}$ and its gate and source connected to the drain of device 153 and to line 165. Devices 155—160 each have their drains connected to line 165 and their sources connected to line 152. The gates of devices 155—160 are connected to a particular combination of address bits A5—A10, respectively. The $2^6$ possible combinations of the six address bits A5—A10 give 64 different word line decoders. The word line decoder shown in Fig. 9 also comprises a depletion mode transmission gate 161 whose drain is connected to line 165, whose source is connected to line 168, and whose gate is controlled by signal $\overline{PGE}$. Another depletion mode transmission gate 162 has its drain connected to line 152, its source connected to line 169, and its gate controlled by signal $\overline{PGE}$. Line 168, representing word line n, is connected to the gate and source of depletion mode device 164, whose drain is connected to the source of depletion mode device 163. The gate and drain of depletion mode device 163 are connected to $V_{pp}$. Line 169, representing word line n+1, is connected to the gate and source of depletion mode device 167, whose drain is connected to the source of depletion mode device 166. The gate and drain of depletion mode device 166 are connected to $V_{pp}$. Lines 168 and 169 are both high voltage lines during the programming mode.

EPROM Column Decoding Circuitry

Fig. 10A and 10B together show a circuit diagram of a portion of the EPROM column decoding circuitry. In Fig. 10A, lines 200—215 represent the 16 bit sense lines associated with one of the eight EPROM word columns. Bit sense lines 200—207 are enabled when the column enable signal (COLENBi) and address bit A0 are both high, and bit sense lines 208—215 are enabled when COLENBi is high and address bit $\overline{A0}$ is high. A particular one of eight column decoding circuits 190 is shown in dashed out-line, is illustrated, the remaining column decoding circuits 191—197 being substantially identical to column decoding circuit 190. Each column decoding circuit, when selected, generates an output which enables a pair of bit sense lines in each word column. For example, circuit 190 generates an output, for an appropriate combination of address bits A1—A3, which renders transistors 230 and 231 conductive. It will be understood that an output signal generated over line 188 also renders conductive similarly situated pairs of transistors in the other seven word columns (not shown).

Column decoding circuit 190 comprises transistors 181—183 whose drains are connected to line 184 and whose sources are connected to ground. The gates of transistors 181—183 are connected to a particular combination of address bits A1—A3 or the complements thereof. For example, transistors 181—183 of circuit 190 may have their gates coupled to A1, A2, and A3, respectively. The corresponding transistors in circuit 191 may have their gates connected to A1, A2, and $\overline{A3}$, respectively, and so on, with the corresponding transistors in circuit 197 having their gates connected to $\overline{A1}$, $\overline{A2}$, and $\overline{A3}$, respectively.

Circuit 190 further comprises a depletion mode transistor 180 whose drain is connected to $V_{DD}$ and whose gate and source are connected to line 184. A depletion mode transistor 185 has its drain connected to line 184, its gate connected to signal $\overline{PGE}$, and its source connected to line 188. Line 188 is connected to the gate and source of a depletion mode transistor 187, whose drain is connected to the source of depletion mode transistor 186. Depletion mode transistor 186 has its gate and drain connected to $V_{pp}$.

The output COLSENSi of the word column shown in Fig. 10A is generated over line 121. Lines 121, 188, and 200—215 are all high voltage lines during the programming mode (and when properly selected).

Fig. 10B illustrates two representative storage cells 220 and 221 in the EPROM array proper. It will be understood that in the EPROM array a programmable transistor is located at every node (i.e., at the intersection of every bit sense line and word line). The programmable transistors such as transistors 220 and 221 in Fig. 10B have a floating gate, represented by a dashed line. When the EPROM is erased, as by exposure to ultraviolet radiation, the charge level on the floating gate is reduced, thereby lowering the threshold voltage of the transistor to approximately 2.0—2.5 volts. During the EPROM programming operation, charge is injected into the floating gate of each transistor representing a stored binary 1, thereby increasing the threshold voltage to approximately 7 volts or greater. For those transistors representing a stored binary 0, no charge is injected into the floating gate.

Miscellaneous Circuitry

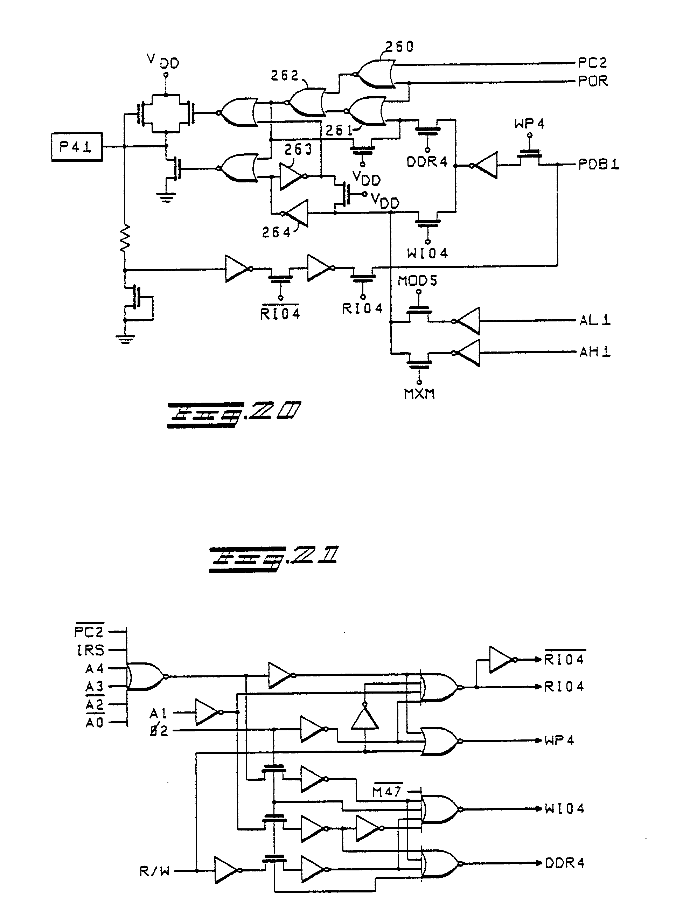

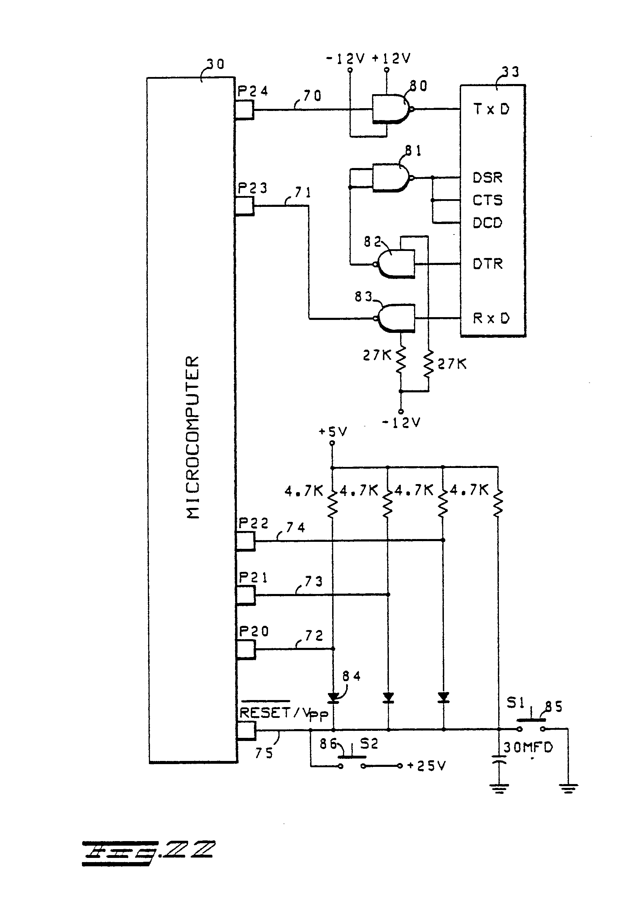

Fig. 11 shows a circuit diagram of a representative sense amp associated with a word column. There are eight sense amps, one for each word column. The sense amp of Fig. 11 receives as an input thereto the COLENSi signal over line 121 and generates an output signal PDBi over line 240, assuming that the sense amp is enable by signal ROMR. Referring to Fig. 12, signal ROMR is generated when signals RR, R/W and Ø2 are all high. Signal RR is, in turn, generated when R/W is high, and the particular address on the microcomputer address bus represents an address within the EPROM address space (i.e., $F800—$FFFF).

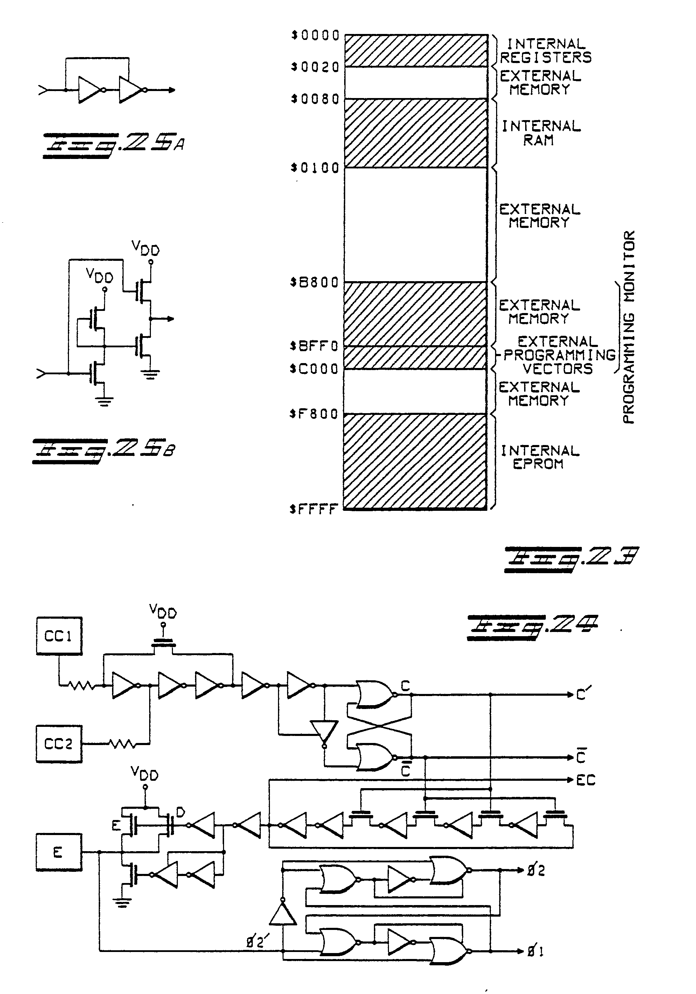

Figs. 13—21 represent various logic diagrams illustrating such portions of the microcomputer reset, strobe control, port 3 circuitry, and port 4 circuitry as to enable one skilled in the art to understand and practice the invention. Since these figures are not primarily directed to the core of the present invention, they will be discussed only in general terms.

Fig. 13 shows a combined logic and circuit diagram of a portion of the reset circuit. RESET/ $V_{pp}$ 51 supplies either the RESET or programming potential $V_{pp}$ over line 23. The programming potential $V_{pp}$ is transmitted over line 55 to the appropriate portions of the circuitry shown in Figs. 7—10 requiring $V_{pp}$. The circuit shown in Fig. 13 also generates POR (Power-On Reset), VRBIAS, and MODL signals.

Fig. 14 shows a logic diagram of the strobe control 1 buffer circuit for generating an address strobe (AS) signal. The AS signal enables the latching of valid addresses by latch 47 (Fig. 1) when port 3 is operating in the multiplexed address/data mode. The external memory/register select signal (EIOS) in Fig. 14 represents an address decoding signal for memory locations $0100—$01FF.

In Fig. 14 signals C and $\overline{C}$ represent a two-phase, non-overlapping clock provided by the crystal oscillator 31 using the clock circuitry shown in Fig. 24. The EC signal generated by the clock circuitry of Fig. 24, representing a logically true equivalent of the E signal, is used to force the AS signal low when signal E is high. The clock generator can also be driven by a TTL gate. The duty cycle of the TTL signal must be 50±10%, and its frequency should be four times the desired E frequency. In Fig. 14 the NMXM and M47 signals are provided by the circuitry of Figs. 16 and 18, respectively.

Fig. 15 shows a logic diagram of a representative one of the port 3 I/O buffers. Port 3 is a multifunctional 8-bit port that serves, depending upon the microcomputer mode, as an I/O port with handshake, as a data port, or as a multiplexed address and data port. Port 3 comprises two major functional blocks, including the I/O buffer circuitry shown in Fig. 15 and the control logic shown in Figs. 18 and 19. In Fig. 15, NOR gates 250—252 form a data direction register. Inverters 253 and 254, connected in a feedback arrangement, form an output data register. Inverters 255 and 256, also coupled in a feedback arrangement, form an input data register.

The control signals generated by the port 3 control logic will now be discussed. Signal M47 is a mode select signal for modes 4 and 7. Signal WP3 (write to port 3) is a signal which goes high to indicate an MPU write to either the output data register or the data direction register. Signal WIO3 is a signal which, after a one-half cycle delay, goes high to indicate an MPU write to the output data register. Signal DDR3 is a signal which after a one-half cycle delay, goes high to indicate an MPU write to the data direction register. Signal DIBP is a signal which couples the peripheral data bus (PDB) 60 to the internal data bus of the MPU during an MPU read operation whenever the MPU addresses internal memory or internal registers (i.e., addresses $0000—$001F, excluding the Port 3 data register at address $0006). Signal DIB3 is a signal which couples the data from the input data register of Port 3 to the internal data bus of the MPU during an MPU read operation whenever DIBP is not active. Signal P3R is the port 3 input latch signal, and it is enabled by the latch enable bit (SR3) of the port 3 control/status register at location $000F. If this bit is cleared, P3R will stay high. If this bit is set, P3R will drop low on a negative transition of the input to the input strobe pin IS3, thus latching the input data to port 3. In modes 4 and 7, known as the single-chip mode, pin SC1 becomes an input strobe pin IS3 to indicate that valid data being input to port 3 is to be latched.

Single DBRW3 is a signal which controls the three-state input to the output drivers. Signal LADD is a control signal used to load the low byte addresses (A0—A7) into the port 3 output drivers. Signal DWR is a signal which couples the internal peripheral data bus (PDB) 60 into the port 3 output driver.

When port 3 is operated in mode 0 a two-cycle delay is added to the POR signal in the DBRW3 and DIBP logic of Fig. 19. The first two cycles after signal POR goes high, when the MPU is fetching the restart vector (addresses $FFFE and $FFFF), signal DBRW3 forces port 3 to be an input during E, and DIBP couples the external data into the MPU.

In Fig. 18 the SR7 signal is the IS3 flag bit. It is a read-only status bit which is stored in the port 3 control/status register which is set by the falling edge of the input strobe IS3. It is cleared by a read of the port 3 status/control register, followed by either a read or write to port 3. It is also cleared by the POR signal.

In Fig. 19 the ROMS signal is the EPROM select signal, and the RAMS signal is the RAM select signal. These signals are generated by appropriate address decoding circuitry corresponding to the EPROM and RAM locations within the microcomputer address space.

Fig. 16 shows a logic diagram for generating the MXM and MOD5 control signals used in the port 4 I/O buffer circuit illustrated in Fig. 20. In Fig. 16 signals PC0—PC2 represent the mode control signals.

Fig. 17 shows a logic diagram for generating the internal register select (IRS) signal which is employed as a control signal in both the port 3 and the port 4 control logic. The IRS signal is low when an internal register within the address space $0000—$001F is selected for a read or write operation.

Fig. 20 shows a logic diagram illustrating a representative one of the port 4 I/O buffer circuits, and Fig. 21 shows a logic diagram illustrating a portion of the port 4 control logic.

Port 4 is an 8-bit port that performs both I/O and address output functions depending upon the selected mode of operation. In mode 0, the EPROM programming mode, port 4 outputs the high byte addresses A8—A15. Port 4 comprises two major functional blocks, including the I/O buffer circuitry shown in Fig. 20 and the control logic circuitry shown in Fig. 21. The I/O buffer circuitry of Fig. 20 includes an output data register comprising inverter 263 and 264 coupled in a feed-back arrangement and a data direction register comprising NOR gates 260—262. The port 4 control logic generates a read signal RIO4 and three write signals, WP4, DDR4, and WIO4. Signal WP4 goes high during E whenever the MPU writes to either the output data register or the data direction register of port 4. Signal DDR4 goes high one-half cycle after the MPU writes to the data direction register of port 4. Signal WIO4 goes high one-half cycle after the MPU writes to the output data register of port 4.

In mode 0, all bits in the port 4 data direction register are set, and port 4 is configured to output the high-order address bits A8—A15. All control signals, RIO4, WP4, WIO4, and DDR4 are inhibited and the high byte addresses are automatically connected to the output buffers via the output data register.

EPROM Programming Monitor

The programming monitor is a computer program which is used to control the CPU 1 of microcomputer 30 to program the EPROM 3. In the preferred embodiment the programming monitor is resident in external ROM 40, within address space $B800—$BFFF of the microcomputer, as shown in Fig. 23. It will be understood that the programming monitor *per se* does not constitute part of the present invention.

Under the control of the programming monitor, CPU 1 is capable of performing a large variety of programming and verifying functions. For example, the programming monitor includes commands which permit the user to load a program from an external source, such as external RAM 41, into the internal RAM 2 of microcomputer 30. Another command allows the user to verify that the program loaded into the internal RAM 2 was properly loaded. Additional commands permit the user to punch the program stored in the internal microcomputer memory onto tape, to examine and change data in a memory location, to calculate the proper offset for relative addressing, to examine and change data in the microcomputer special registers, to display blocks of memory, to change and display break points, to trace through the user's program, and so on.

The important commands relative to the present invention are the command for determining that the EPROM3 has been properly erased prior to the programming operation, the command with which to declare the crystal frequency in order to provide the proper duration of application of the programming potential $V_{pp}$, the command to program the EPROM 3 with the desired data, and finally the command to verify that the data loaded into the EPROM 3 is correct.

With reference to determining whether the EPROM 3 is in an erased state, the EPROM checking command is in the form: CHCK (AAAA) (BBBB), where AAAA and BBBB represent the beginning and ending addresses of the portion of the EPROM which it is desired to check. If any EPROM location is determined to be non-erased, an error print routine is used to identify such location to the user.

The crystal frequency determining command is set forth on a line of the program monitor. The user must identify the crystal frequency as either 2.45 or 4.91 MHz, in order for the programming circuit associated with the EPROM to supply the $V_{pp}$ potential to the EPROM for a duration of 50 sec.

The EPROM programming command is set forth on another line of the program monitor and is of the form: PROG (XXXX) (YYYY) (AAAA), where XXXX and YYYY are non-EPROM addresses within the microcomputer address space and wherein AAAA is the desired beginning EPROM address. This program segment of the programming monitor checks that the beginning EPROM address is a valid EPROM address. It also checks to be sure that the number of bytes of data to be programmed into the EPROM will fit into that portion of the EPROM beginning at the designated EPROM address. The EPROM programming routine also verifies that the EPROM section to be programmed is properly erased. The addresses of any non-zero bytes within the EPROM are printed out with the values at such addresses, as for the CHCK command discussed above. The user is given an option of proceeding with EPROM programming even though the EPROM memory is not clear. Next the user is instructed to turn on the 25 volt programming potential by closing switch 86 (Fig. 22), thereby applying $V_{pp}$ to the $\overline{RESET}/V_{pp}$ pin. The EPROM is then programmed in the manner to be discussed in further detail below. Next the user is requested to disconnect the $V_{pp}$ potential.

Finally, using the verify command set forth beginning at line 01519 of the programming monitor, the programmed contents of the EPROM are compared for accuracy against the source of the data which was loaded into the EPROM.

The verify command has the form; VERF (XXXX) (YYYY) (AAAA), where the variables have the same meaning as for the PROG command described above. If an error is found during the verification operation, the address at which the error is found is printed along with the EPROM contents at such address and the memory contents which failed to be properly loaded.

In the preferred embodiment, EPROM 3 may be programmed with data from either the external RAM 41 or with data entered directly from terminal 33. However, it will be understood that, through appropriate peripheral equipment and interfaces, data may be loaded into EPROM 3 from a variety of other data sources.

Operation of Preferred Embodiment

Before proceeding with a description of the operation of the preferred embodiment, it should be mentioned that the memory map for the processor interrupt vectors in mode 0 is changed to $BFF0—$BFFF from $FFF0—$FFFF. Since $BFF0—$BFFF is located in external RAM or ROM memory space when CPU1 is reset in mode 0 viable interrupt vectors will exist, despite the microcomputer EPROM 3 having been erased. The external interrupt vectors are associated with a computer program (e.g., the programming monitor) which is stored in external memory space and is used by the CPU 1 to control the programming of EPROM 3.

When EPROM 3 has been erased, as by exposure to ultraviolet light, all of its floating gate transistors, each representing a data bit in the memory array, have no charge on their gates, so that in effect each EPROM data bit is in the 0 state. It is desired to effectively program 1's into certain bit locations, and this is accomplished in a well-known manner by applying the programming potential $V_{pp}$ to the gates of those transistors which are to represent binary 1's. The manner by which the EPROM floating gate transistors are programmed in the present invention will now be described.

To initiate the EPROM programming operation, the user closes switch 85 (Fig. 22), which pulls pins P20—P22 essentially to ground, causing mode selection signals each to be 0, representing mode 0. At the same time the potential on the $\overline{RESET}/V_{pp}$ pin is drawn towards ground, causing microcomputer 30 to go into reset. The mode 0 reset vector is fetched from addresses $BFFE and $BFFF, which allow the external computer program stored in external ROM 40 to be used by CPU 1 to program the EPROM 3.

After performing a check to determine whether all storage locations in EPROM 3 have been erased, an instruction in the EPROM programming monitor sets the appropriate program latch enable ($\overline{PLE}$) bit to 0 in the EPROM control register (Fig. 5). This conditions the EPROM 3 for programming by permitting address and data information to be latched in the address buffer/latch 61 and data latch 62 (Fig. 4), respectively, when the $\overline{R/W}$ signal is low and Ø2' is high. Next the programming monitor instructs the terminal printer to print a message to the user requesting him to turn on the programming potential $V_{pp}$. The user closes switch 86 (Fig. 22) to apply 25 volts to the $\overline{RESET}/V_{pp}$ pin from where $V_{pp}$ is distributed as required to the EPROM programming circuitry shown in Figs. 9, 10A, 10B and 11. The EPROM 3 is now ready for programming at the desired locations. The EPROM may be programmed at locations which are either continuous or non-continuous and may be loaded in either a sequential or random manner. It will be understood that valid data may not be read from the EPROM when the 25 volt programming potential is connected to the $\overline{RESET}/V_{pp}$ pin.

To program data into a particular address into the EPROM, the address and associated data are latched into the address buffer/latch 61 and data latch 62, respectively, shown in Fig. 4. The data latch is shown in greater detail in Fig. 7, and the address buffer/latch is shown in Fig. 8. As seen in Fig. 7 and 10A, when the program enable signal ($\overline{PGE}$) is set to 0 for a 50 msc duration by CPU 1 under control of the programming monitor, a binary 1 stored in a particular data latch/buffer such as shown in Fig. 7 will cause signal COLENBi to go high, thereby enabling its associated column select circuitry (Fig. 10A) by allowing $V_{pp}$ to conduct through transistor 120 to line 121. A particular one of the bit sense lines 200—215 in Fig. 10A will be enabled by the particular combination of address bits A1—A3 and their complements when signal $\overline{PGE}$ is low. For example, if the gates of transistors 181—183 in column decoder 190 of Fig. 10A are each connected to the true outputs A1—A3 of the appropriate address buffer/latches, and if address bits A1—A3 for a given address on address bus 56 are each 0, none of transistors 181—183 will be conductive, and the potential at the source of transistor 185 will be essentially $V_{DD}$. If signal $\overline{PGE}$ is high, potential $V_{pp}$ will conduct through depletion and transistors 186, 187 and 185 to $V_{DD}$, and transistors 230 and 231 will not be enabled. If signal $\overline{PGE}$ is low, depletion device 185 will be turned off, and potential $V_{pp}$ will be transmitted over line 188 to devices 230 and 231. If signal $\overline{PGE}$ is low, and any of address bits A1—A3 are high, causing any of transistors 181—183 to be turned on, the potential at the source of device 185 will be substantially ground, and device 185 will be conductive since it is a depletion device and is conductive when its gate-to-source potential is 0 or higher. Consequently neither transistors 230 or 231 will be turned on for this condition.

Similarly, regarding the word line decoder shown in Fig. 9, when signal $\overline{PGE}$ is high, potential $V_{pp}$ conducts through transistors 161 and 162 to potential $V_{DD}$ or to ground, depending upon whether address bit A4 is low or high. When

signal $\overline{PGE}$ is low, and transistor 153 is not enabled (i.e., address bit A4 is low), potential $V_{pp}$ will be transmitted over line 168, assuming that none of transistors 155—156 have turned on. If any of transistors 155—160 are conductive, the source of transistor 161 will be substantially 0, since transistor 150 is conductive, and depletion transistor 161 will be conductive since its gate-to-source potential is approximately 0, causing $V_{pp}$ to shunt to ground.

Regarding the address buffer/latch shown in Fig. 8, when signal $\overline{PGE}$ is high, $V_{pp}$ conducts through transistors 130 to 139 to the $V_{DD}$ potentials associated with inverters 136 and 137. When signal $\overline{PGE}$ goes low, if the output of inverter 136 is high, the gate-to-source potential of depletion transistor 138 is negative, causing such transistor to become non-conductive, and $V_{pp}$ is transmitted on line 144. Since for this condition the output of inverter 137 is low, depletion transistor 139 will remain conductive, and $V_{pp}$ will be conducted to $V_{DD}$, causing line 145 to remain low.

When signal $\overline{PGE}$ goes low for a 50 msec duration, the programming potential $V_{pp}$ is applied to all of the gates of the floating gate transistors in the particular word line which is selected by the appropriate combination of address bits A4—A10. For example, if the word line decoder shown in Fig. 9 is selected by the appropriate combination of address bits A4—A10, causing word line n+1 to transmit $V_{pp}$ over line 169, the gate of transistor 220 in Fig. 10B will rise to the programming potential, as will the gates of all other transistors similarly situated at the intersections of line 169 and all of the 128 bit sense lines, of which only lines 200—215, representing the bit sense lines of one column, are shown in Fig. 10B. Only floating gate transistors 220 and 221 are illustrated in Fig. 10B, but it will be understood by one skilled in the art that a floating gate transistor is situated at each of the intersections of the word lines 1—128 and the 128 bit sense lines.

Depending upon the particular address of the EPROM location which is being programmed, one of the bit sense lines in each column of the EPROM array will be enabled when either transistors 170 or 171 is rendered conductive and when one of the column decoders 190—197 generates an output in response to the appropriate combination of address bits A1—A3. Programming potential $V_{pp}$ is then transmitted through transistors 120, through transistors 170 or transistors 171, and through the particular transistors enabled by one of the column decoders 190—197, causing $V_{pp}$ to be applied to the drain of the floating gate transistor at the intersection of the selected word line, e.g., transistor 220 at the intersection of lines 169 and 200. By the avalanche injection of charge onto the floating gate of such transistor, the threshold voltage of the transistor is increased to greater than 7 volts. Thus, if the data input latch shown in Fig. 7 represents the data input latch associated with the least significant data bit, and the column shown in Fig. 10A is also associated with the least significant data bit, a binary 1 latched into the data latch of Fig. 7 will cause the address-selected floating gate transistor (e.g., floating gate transistor 220 to be programmed as a binary 1 also. If the least significant bit were a binary 0, the column enable signal (COLENB 1) would not be generated by the data input latch of Fig. 7, and the address-selected floating gate transistor would not have a charge injected into its floating gate, since $V_{pp}$ would not be transmitted through gate 120 of the column select circuit of Fig. 10A, and this transistor would store a binary 0. This completes the description of the EPROM programming operation.

Upon conclusion of the EPROM programming operation, $V_{pp}$ is reset to 5 volts from 25 volts, and an instruction in the EPROM programming monitor sets $\overline{PLE}$ high again to allow normal read operation of the EPROM 3. During an EPROM read operation, if the floating gate transistor at the intersection of a selected word line (e.g., word line n+1) and a selected bit sense line in a particular column (e.g., sense line 200) is storing a binary 1, such transistor (i.e., transistor 220) will fail to turn on since its threshold voltage is greater than 7 volts. $V_{pp}$ is 5 volts during normal read operations, and will be transmitted over line 121 to inverters 271 and 272 of the sense amp shown in Fig. 11, each of which generates a low output to gates 275 and 274, respectively. Depletion mode transistor 276 transmits a high output to inverter 277, which in turn transmits a low output to inverter 278. Gate 280 conducts $V_{DD}$ through gate 282 (assuming gate 282 has been turned on by the ROM read signal ROMR), and accordingly a binary 1 is transmitted over peripheral data bus line 240. In the event the address-selected, programmed floating gate transistor 220 is storing a binary 0, $V_{pp}$ is shunted to ground through gate 220, since its threshold voltage remains at 2.0—2.5 volts. The output of inverter 272 goes high, causing transistor 274 to conduct $V_{DD}$ through depletion mode transistor 276 to ground. The output of inverter 277 goes high, permitting $V_{DD}$ to be conducted through depletion mode transistor 281 to ground. The output of the corresponding peripheral data bus line 240 thus represents a binary 0 for this condition.

The timer 4 of microcomputer 30 which is utilized to set the program enable signal PGE low for a 50 msec duration may be a timer readable by the central processing unit, in the same manner in which CPU 1 may read timer 4.

It will be understood that switches S1 and S2 in Figure 22 may be electrically operated in response to control signals from microcomputer 30 under the direction of the external computer program.

It will be appreciated that the present invention results in substantial cost savings to the user, since the on-board processor of the single-chip microcomputer is used to program the EPROM of the microcomputer. It is therefore unnecessary to utilize a separate processor. In addition, it is not necessary to provide pins dedicated solely to the EPROM programming operation, and these pins can be used to advantage to provide other capabilities in the microcomputer.

**Claims for the Contracting States: DE, FR, GB**

1. A microcomputer arrangement comprising:—

an erasable programmable read only memory (EPROM) (3);

programming circuitry (53) operative in response to the application of a programming potential (VPP) thereto for programming data into selected addresses in the EPROM;

input/output circuitry (13, 14) for receiving control programs and data to be programmed into respective addresses in the EPROM;

and a processor (1) adapted to execute said control programs;

characterised in that the programming circuitry (53) is coupled to an address latch (61) for storing an address provided thereto coincident with a latch enable signal (LENB) and to a data latch (62) for storing data provided thereto coincident with said latch enable signal, said programming circuitry being responsive to a program enable signal (PGE) to program the data stored in the data latch into the EPROM at the address stored in the address latch;

said processor (1) executes a selected one of said control programs to provide sequentially to the address latch, coincident with the latch enable signal, an address to be programmed in the EPROM, and to the data latch, coincident with the latch enable signal, the data to be programmed at said address in the EPROM, and then the program enable signal to the programming circuitry;

an external read only memory (40) is connected to the input/output circuitry of the microcomputer for storing at least said selected control program; and the EPROM, programming circuitry, input/ output circuitry and processor being provided as a single chip microcomputer.

2. A microcomputer arrangement as claimed in claim 1 wherein an external random access memory (41) is connected to said input/output circuitry of said microcomputer for temporarily storing information generated by said processor during programming of said EPROM and/or for providing data to be programmed into said EPROM via said programming circuitry.

3. A method of programming the EPROM in the microcomputer arrangement of claim 1 comprising the following steps:—

(a) coupling a source of address and data information (41) to the input/output circuitry (13, 14) of said microcomputer (30) to provide data and control programs therefor;

(b) supplying the programming potential (VPP) to said programming circuitry (53);

(c) operating the processor (1) to execute said selected one of said control programs which is adapted to sequentially provide a selected plurality of said addresses and respective data to said programming circuitry, each coincident with a respective latch enable signal (LENB) followed by a respective program enable signal (PGE), to program the EPROM in said microprocessor.

4. A method of programming as claimed in claim 3 wherein said selected control program is adapted to control the processor to compare the data programmed into said EPROM with that provided by said source.

**Claims for the Contracting State: NL**

1. A microcomputer arrangement comprising:—

an erasable programmable read only memory (EPROM) (3);

programming circuitry (53) operative in response to the application of a programming potential (VPP) thereto for programming data into selected addresses in the EPROM;

input/output circuitry (13, 14) for receiving control programs and data to be programmed into respective addresses in the EPROM;

and a processor (1) adapted to execute said control programs;

characterised in that the programming circuitry (53) is coupled to an address latch (61) for storing an address provided thereto coincident with a latch enable signal (LENB) and to a data latch (62) for storing data provided thereto coincident with said latch enable signal, said programming circuitry being responsive to a program enable signal (PGE) to program the data stored in the data latch into the EPROM at the address stored in the address latch;

and said processor (1) executes a selected one of said control programs to provide sequentially to the address latch, coincident with the latch enable signal, an address to be programmed in the EPROM, and to the data latch, coincident with the latch enable signal, the data to be programmed at said address in the EPROM, and then the program enable signal to the programming circuitry;

the EPROM, programming circuitry, input/ output circuitry and the processor being provided as a single chip microcomputer.

2. A microcomputer arrangement as claimed in claim 1 wherein an external read only memory (40) is connected to said input/output circuitry of said microcomputer for storing at least said selected control program.

3. A microcomputer arrangement as claimed in claim 1 wherein an external random access memory (41) is connected to said input/output circuitry of said microcomputer for temporarily storing information generated by said processor during programming of said EPROM and/or for providing data to be programmed into said EPROM via said programming circuitry.

4. A method of programming the EPROM in the microcomputer arrangement of claim 1 comprising the following steps:—

(a) coupling a source of address and data information (41) to the input/output circuitry (13, 14) of said microcomputer (30) to provide data and control programs therefor;

(b) supplying the programming potential (VPP) to said programming circuitry (53);

(c) operating the processor (1) to execute said selected one of said control programs which is adapted to sequentially provide a selected plurality of said addresses and respective data to said programing circuitry, each coincident with a respective latch enable signal (LENB) followed by a respective program enable signal (PGE), to program the EPROM in said microprocessor.

5. A method of programming as claimed in claim 4 wherein said selected control program is adapted to control the processor to compare the data programmed into said EPROM with that provided by said source.

**Patentansprüche für die Vertragsstaaten: DE, FR, GB**

1. Eine Microcomputeranordnung mit:

einem löschbaren programmierbaren Nur-Lese-Speicher (EPROM) (3);

einer programmierbaren Schaltung (53), die in Reaktion auf das Anlegen einer programmierenden Spannung (VPP) an diese betätigbar ist, um Daten in ausgewählter Adressen in das EPROM zu programmieren;

einer Eingangs/Ausgangs-Schaltung (13, 14) zum Empfangen von Steuerprogrammen und an jeweiligen Adressen in dem EPROM zu programmierenden Daten;

und einem Prozessor (1), der geeignet ist, um die Steuerprogramme auszuführen;

dadurch gekennzeichnet, daß die programmierende Schaltung (53) an ein Adreßgatter (61) angeschlossen ist, um eine zu dieser zugeführte Adresse, die mit einem Gatteraktivierungssignal (LENB) übereinstimmt, abzuspeichern, und die an ein Datengatter (62) angeschlossen ist, um dieser zugeführte Daten, die mit dem Gatteraktivierungssignal übereinstimmen abzuspeichern, wobei die programmierende Schaltung auf ein Programmaktivierungssignal (PGE) anspricht, um in dem Datengatter gespeicherte Daten in das EPROM unter der Adresse abzuspeichern, die in dem Adreßgatter gespeichert ist;

daß der Prozessor (1) ein Ausgewähltes aus den Steuerprogrammen ausführt, um der Reihe nach zu dem Adreßgatter in Übereinstimmung mit dem Gatteraktivierungssignal eine in das EPROM zu programmierende Adresse zuzuführen, und um zu dem Datengatter in Übereinstimmung mit dem Gatteraktivierungssignal die unter der Adresse in dem EPROM zu programmierenden Daten zuzuführen, und um daraufhin das Programmaktivierungssignal zu der programmierenden Schaltung zuzuführen;

daß ein äußerer Nur-Lese-Speicher (40) an die Eingangs/Ausgangs-Schaltung des Mikrocomputers zum Speichern von zumindest dem ausgewählten Steuerprogramm angeschlossen ist; und

daß das EPROM die programmierende Schaltung, die Eingangs/Ausgangs-Schaltung und der Prozessor als Einzel-Chip-Microcomputer ausgeführt sind.

2. Microcomputeranordnung nach Anspruch 1, bei der ein äußerer Speicher (41) mit wahlfreiem Zugriff an die Eingangs/Ausgangs-Schaltung des Microcomputers zum zeitweiligen Speichern von Information, die durch den Prozessor während des Programmierens des EPROM erzeugt wird, und/oder zum Zuführen von zu programmierende Daten zu dem EPROM mittels der programmierenden Schaltung angeschlossen ist.

3. Ein Verfahren des Programmierens des EPROM bei der Microcomputer-Anordnung nach Anspruch 1, mit folgenden Verfahrensschritten:

a) Anschließen einer Quelle für Adreß- und Daten-Information (41) an die Eingangs/Ausgangs-Schaltung (13, 14) des Microcomputers (30), um diesen mit Daten und Steuerprogrammen zu beliefern;

b) Zuführen der programmierenden Spannung (VPP) zu der programmierenden Schaltung (53);

c) Betätigen des Processors (1), um ein Ausgewähltes aus den Steuerprogrammen auszuführen, das dazu geeignet ist, der Reihe nach eine ausgewählte Mehrzahl der Adressen und jeweiligen Daten zu der programmierenden Schaltung zuzuführen, die jeweils mit einem jeweiligen Gatteraktivierungssignal (LENB) übereinstimmen, denen ein jeweiliges Programmaktivierungssignal (PGE) folgt, um das EPROM in dem Microprozessor zu programmieren.

4. Ein Verfahren des Programmierens gemäß Anspruch 3, bei dem das ausgewählte Steuerprogramm dazu geeignet ist, den Prozessor zu steuern, um die in das EPROM programmierten Daten mit den durch die Quelle gelieferten Daten zu vergleichen.

**Patentansprüche für den Vertragsstaat: NL**

1. Eine Microcomputeranordnung mit:

einem löschbaren programmierbaren Nur-Lese-Speicher (EPROM) (3);

einer programmierbaren Schaltung (53), die in Reaktion auf das Anlegen einer programmierenden Spannung (VPP) an diese betätigbar ist, um Daten in ausgewählter Adressen in das EPROM zu programmieren;

einer Eingangs/Ausgangs-Schaltung (13, 14) zum Empfangen von Steuerprogrammen und an jeweiligen Adressen in dem EPROM zu programmierenden Daten;

und einem Prozessor (1), der geeignet ist, um die Steuerprogramme auszuführen;

dadurch gekennzeichnet, daß die programmierende Schaltung (53) an ein Adreßgatter (61) angeschlossen ist, um eine zu dieser zugeführte Adresse, die mit einem Gatteraktivierungssignal (LENB) übereinstimmt, abzuspeichern, und die an ein Datengatter (62) angeschlossen ist, um dieser zugeführte Daten,

die mit dem Gatteraktivierungssignal Übereinstimmen, abzuspeichern, wobei die programmierende Schaltung auf ein Programmaktivierungssignal (PGE) anspricht, um in dem Datengatter gespeicherte Daten in das EPROM unter der Adresse abzuspeichern, die in dem Adreßgatter gespeichert ist;

daß der Prozessor (1) ein Ausgewähltes aus den Steuerprogrammen ausführt, um der Reihe nach zu dem Adreßgatter in Übereinstimmung mit dem Gatteraktivierungssignal eine in das EPROM zu programmierende Adress zuzuführen, und um zu dem Datengatter in Übereinstimmung mit dem Gatteraktivierungssignal die unter der Adresse in dem EPROM zu programmierenden Daten zuzuführen, und um daraufhin das Programmaktivierungssignal zu der programmierenden Schaltung zuzuführen;

daß das EPROM, die programmierende Schaltung, die Eingangs/Ausgangs-Schaltung und der Prozessor als Einzel-Chip-Microcomputer ausgeführt sind.

2. Eine Microcomputeranordnung nach Anspruch 1, bei der äußere Nur-Lese-Speicher (40) an die Eingangs/Ausgangs-Schaltung des Microcomputers zum Speichern zumindest des ausgewählten Steuerprogrammes angeschlossen ist.

3. Eine Microcomputeranordnung nach Anspruch 1, bei der der äußere Speicher mit wahlfreiem Zugriff (41) an die Eingangs/Ausgangs-Schaltung des Microcomputers angeschlossen ist, um zeitweilig Informationen zu speichern, die durch den Prozessor während des Programmierens des EPROM erzeugt werden, und/oder zum Erzeugen von in das EPROM mittels der programmierenden Schaltung zu programmierenden Daten.

4. Ein Verfahren des Programmierens des EPROM, bei der Microcomputer-Anordnung nach Anspruch 1, mit folgenden Verfahrensschritten:

a) Anschließen einer Quelle für Adreß- und Daten-Information (41) an die Eingangs/Ausgangs-Schaltung (13, 14) des Microcomputers (30), um diesen mit Daten und Steuerprogrammen zu beliefern;

b) Zuführen der programmierenden Spannung (VPP) zu der programmierenden Schaltung (53);

c) Betätigen des Prozessors (1), um ein Ausgewähltes aus den Steuerprogrammen auszuführen, das dazu geeignet ist, der Reihe nach eine ausgewählte Mehrzahl der Adressen und jeweiligen Daten zu der programmierenden Schaltung zuzuführen, die jeweils · mit einem jeweiligen Gatteraktivierungssignal (LENB) übereinstimmen, denen ein jeweiliges Programmaktivierungssignal (PGE) folgt, um das EPROM in dem Microprozessor zu programmieren.

5. Ein Verfahren des Programmierens gemäß Anspruch 4, bei dem das ausgewählte Steuerprogramm dazu geeignet ist, den Prozessor zu steuern, um die in das EPROM programmierten Daten mit den durch die Quelle gelieferten Daten zu vergleichen.

**Revendications pour Etats Contractants: DE, FR, GB**

1. Agencement de microordinateur comprenant:

une mémoire morte programmable effaçable (EPROM) (3);

un circuit de programmation (53) agissant en réponse à l'application d'un potentiel de programmation ($V_{pp}$) pour programmer des données dans des adresses choisies de l'EPROM;

un circuit d'entrée/sortie (13, 14) pour recevoir des programmes de commande et des données à programmer dans des adresses respectives de l'EPROM; et

un processeur (1) adapté à exécuter les programmes de commande;

caractérisé en ce que le circuit de programmation (53) est couplé à une bascule d'adresse (61) pour mémoriser une adresse qui lui est fournie en coïncidence avec un signal de validation de bascule (LENB) et à une bascule de données (62) pour mémoriser des données fournies en coïncidence avec le signal de validation de bascule, ce circuit de programmation agissant en réponse à un signal de validation de programme (PGE) pour programmer les données mémorisées dans la bascule de données dans l'EPROM à l'adresse mémorisée dans la bascule d'adresse;

le processeur (1) exécute l'un choisi des programmes de commande pour fournir séquentiellement à la bascule d'adresse, en coïncidence avec le signal de validation de bascule, une adresse à programmer dans l'EPROM et à la bascule de données, en coïncidence avec le signal de validation de bascule, les données à programmer à ladite adresse de l'EPROM, et ensuite le signal de validation de programme au circuit de programmation;

une mémoire morte externe (40) est connectée au circuit d'entrée/sortie du microordinateur pour mémoriser au moins les programmes de commande choisis; et le circuit de programmation d'EPROM, le circuit d'entrée/sortie et le processeur est prévu sous forme d'un microordinateur monopastille.

2. Agencement de microordinateur selon la revendication 1, dans lequel une mémoire vive externe (41) est connectée au circuit d'entrée/sortie du microordinateur pour mémoriser temporairement des informations produites par le processeur pendant la programmation de l'EPROM et/ou pour fournir des données à programmer dans l'EPROM par l'intermédiaire du circuit de programmation.

3. Procédé de programmation de l'EPROM dans l'agencement de microordinateur selon la revendication 1, comprenant les étapes suivantes:

(a) coupler une source d'informations d'adresses et de données (41) au circuit d'entrée/sortie (13, 14) du microordinateur (30) pour lui fournir des programmes de données et de commande;

(b) fournir le potentiel de programmation (V<sub>pp</sub>) au circuit de programmation (53);

(c) actionner le processeur (1) pour exécuter celui choisi des programmes de commande qui est adapté à fournir séquentiellement une pluralité choisie d'adresses et de données respectives au circuit de programmation, chacune en coïncidence avec un signal de validation de bascule respectif (LENB) suivi par un signal de validation de programme respectif (PGE), pour programmer l'EPROM dans le microprocesseur.

4. Procédé de programmation selon la revendication 3, dans lequel le programme de commande choisi est adapté à commander le processeur pour comparer les données programmées dans l'EPROM à celles fournies par ladite source.

**Revendications pour Etat Contractant: NL**

1. Agencement de microordinateur comprenant:

une mémoire morte programmable effaçable (EPROM) (3);

un circuit de programmation (53) agissant en réponse à l'application d'un potentiel de programmation (V<sub>pp</sub>) pour programmer des données dans des adresses choisies de l'EPROM;

un circuit d'entrée/sortie (13, 14) pour recevoir des programmes de commande et des données à programmer dans des adresses respectives de l'EPROM; et

un processeur (1) adapté à exécuter les programmes de commande;

caractérisé en ce que le circuit de programmation (53) est couplé à une bascule d'adresse (61) pour mémoriser une adresse qui lui est fournie en coïncidence avec un signal de validation de bascule (LENB) et à une bascule de données (62) pour mémoriser des données fournies en coïncidence avec le signal de validation de bascule, ce circuit de programmation agissant en réponse à un signal de validation de programme (PGE) pour programmer les données mémorisées dans la bascule de données dans l'EPROM à l'adresse mémorisée dans la bascule d'adresse;

Le processeur (1) exécute l'un choisi des programmes de commande pour fournir séquentiellement à la bascule d'adresse, en coïncidence avec le signal de validation de bascule, une adresse à programmer dans l'EPROM et à la bascule de données, en coïncidence avec le signal de validation de bascule, les données à programmer à ladite adresse de l'EPROM, et ensuite le signal de validation de programme au circuit de programmation; et

le circuit de programmation d'EPROM, le circuit d'entrée/sortie et le processeur est prévu sous forme d'un microordinateur monopastille.

2. Agencement de microordinateur selon la revendication 1, dans lequel une mémoire morte externe (40) est connectée au circuit d'entrée/sortie du microordinateur pour mémoriser au moins les programmes de commande choisis.

3. Agencement de microordinateur selon la revendication 1, dans lequel une mémoire vive externe (41) est connectée au circuit d'entrée/sortie du microordinateur pour mémoriser temporairement des informations produites par le processeur pendant la programmation de l'EPROM et/ou pour fournir des données à programmer dans l'EPROM par l'intermédiaire du circuit de programmation.

4. Procédé de programmation de l'EPROM dans l'agencement de microordinateur selon la revendication 1, comprenant les étapes suivantes:

(a) coupler une source d'informations d'adresses et de données (41) au circuit d'entrée/sortie (13, 14) du microordinateur (30) pour lui fournir des programmes de données et de commande;

(b) fournir le potentiel de programmation (V<sub>pp</sub>) au circuit de programmation (53);

(c) actionner le processeur (1) pour exécuter celui choisi des programmes de commande qui est adapté à fournir séquentiellement une pluralité choisie d'adresses et de données respectives au circuit de programmation, chacune en coïncidence avec un signal de validation de bascule respectif (LENB) suivi par un signal de validation de programme respectif (PGE), pour programmer l'EPROM dans le microprocesseur.

5. Procédé de programmation selon la revendication 4, dans lequel le programme de commande choisi est adapté à commander le processeur pour comparer les données programmées dans l'EPROM à celles fournies par ladite source.

_Fig.II_

0 029 855

Fig.2

Fig.4

Fig.3

Fig.11

Fig.12

3

Fig.5

Fig.6

Fig.7

Fig.8

Fig. 9

Fig. 14

Fig. 10A

0 029 855

Fig. 10B

_FIG.13_

_FIG.15_

Fig.16

Fig.17

Fig.18

FIG. 19

0 029 855

Fig.20

Fig.21

11

FIG. 22

FIG.25ₐ

FIG.25ᵦ

| | |
|---|---|
| $0000 | INTERNAL REGISTERS |
| $0020 | EXTERNAL MEMORY |
| $0080 | INTERNAL RAM |
| $0100 | EXTERNAL MEMORY |
| $B800 | EXTERNAL MEMORY |
| $BFF0 | EXTERNAL PROGRAMMING VECTORS |
| $C000 | EXTERNAL MEMORY |
| $F800 | INTERNAL EPROM |
| $FFFF | |

PROGRAMMING MONITOR

FIG.23

FIG.24

13